(19) Europäisches Patentamt / European Patent Office / Office européen des brevets

(11) **EP 2 568 602 B1**

(12) **EUROPÄISCHE PATENTSCHRIFT**

(45) Veröffentlichungstag und Bekanntmachung des Hinweises auf die Patenterteilung:
**06.09.2017   Patentblatt 2017/36**

(51) Int Cl.:
***H03G 3/30*** (2006.01)

(21) Anmeldenummer: **12177746.0**

(22) Anmeldetag: **25.07.2012**

(54) **VERFAHREN UND VORRICHTUNG ZUR PEGELREGELUNG EINES GEPULSTEN HOCHFREQUENZSIGNALS**

METHOD AND DEVICE FOR REGULATING THE LEVEL OF A PULSED HIGH FREQUENCY SIGNAL

PROCÉDÉ ET DISPOSITIF DE RÉGULATION DE NIVEAU D'UN SIGNAL HAUTE FRÉQUENCE PULSÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.09.2011   DE 102011082351**

(43) Veröffentlichungstag der Anmeldung:
**13.03.2013   Patentblatt 2013/11**

(73) Patentinhaber: **Rohde & Schwarz GmbH & Co. KG
81671 München (DE)**

(72) Erfinder:
• **Richt, Norbert
  85570 Markt Schwaben (DE)**
• **Danz, Joachim, Dr.
  85521 Ottobrunn (DE)**

(74) Vertreter: **Körfer, Thomas
  Mitscherlich PartmbB
  Patent- und Rechtsanwälte
  Sonnenstrasse 33
  80331 München (DE)**

(56) Entgegenhaltungen:
**US-A- 5 054 116      US-A- 5 661 442
US-A- 5 768 694      US-A1- 2003 112 063**

EP 2 568 602 B1

**Beschreibung**

Die Erfindung betrifft ein Verfahren und eine Vorrichtung zur Pegelregelung eines gepulsten Hochfrequenzsignals.

In Signalgeneratoren können gepulste Hochfrequenzsignale erzeugt werden. Hierbei wird ein von einem FrequenzSynthesizer erzeugtes Hochfrequenzsignal einem Pulsmodulator zugeführt, der von einem Pulssignal angesteuert wird. Während der Dauer der einzelnen Pulse des Pulssignals wird das Hochfrequenzsignal vom Eingang zum Ausgang des Pulsmodulators geleitet. Während der Dauer der einzelnen Pulspausen des Pulssignals erfolgt dagegen keine Weiterführung des Hochfrequenzsignals vom Eingang zum Ausgang des Pulsmodulators.

Bei einer Pegelregelung eines gepulsten

Hochfrequenzsignals wird der Signalpegel des gepulsten Hochfrequenzsignals am Ausgang des Pulsmodulators mit einem Detektor erfasst und mit einem Referenzwert verglichen. In Abhängigkeit dieser Regeldifferenz wird mit einem Pegelregler ein Stellsignal erzeugt, mit dem der Verstärkungs-bzw. Dämpfungsfaktor eines dem Pulsmodulator vorgelagerten Verstärkungs- bzw. Dämpfungsgliedes eingestellt wird. Auf diese Weise wird der Signalpegel des gepulsten Hochfrequenzsignals an den gewünschten Referenzwert geregelt. Aufgrund der zeitlichen Dynamik des Detektors, des Pegelreglers und des Verstärkungs- bzw. Dämpfungsgliedes weist eine derartige Pegelregelung ein begrenzte Regelbandbreite auf, die typischerweise bis zu einigen Megahertz reicht.

Während der Pulspausen des Pulssignals weist der Signalpegel des gepulsten Hochfrequenzsignals einen Wert von Null bzw. von näherungsweise Null auf und kann deshalb vom Detektor nicht erfasst werden. Die Pegelregelung kann deshalb während der Pulspausen des Pulssignals nicht sinnvoll arbeiten. Aus der US 5,054,116 ist es bekannt, während der Pulspausen des Pulssignals die Pegelregelung zu öffnen.

Andererseits ist es der Pegelregelung in kurzen Pulspausen des Pulssignals aufgrund ihrer begrenzten Regelbandbreite nicht möglich, einen Regelvorgang vollständig zu Ende zu führen. Insofern erfolgt bei gepulsten Hochfrequenzsignalen oftmals im Pulsbetrieb überhaupt keine Pegelregelung oder nur in vergleichsweise langen Pulsen des Pulssignals. Ändert sich der Signalpegel des gepulsten Hochfrequenzsignals aufgrund beispielsweise einer Temperaturdrift oder eines anderen Einflusses, so wird der Pulsbetrieb aufgehoben und die Pegelregelung für das ungepulste Hochfrequenzsignal aktiviert. Erreicht der Signalpegel des ungepulsten Hochfrequenzsignals den vorgegebenen Referenzwert, so wird die Pegelregelung ausgeschaltet, der Wert des aktuellen Stellsignals am Pegelregler konstant gehalten und der Pulsbetrieb wieder aktiviert. Pegeländerungen des gepulsten Hochfrequenzsignals bleiben jedoch solange nachteilig bestehen, bis die nächste Pegelregelung aktiviert wird. Die Beaufschlagung eines Meßobjekts mit einem ungepulsten Hochfrequenzsignals während einer länger andauernden Pegelregelung kann beim Messobjekt darüber hinaus unerwünscht zu Schäden führen.

Aufgabe der Erfindung ist es deshalb, eine Vorrichtung und ein Verfahren zur Pegelregelung für ein gepulstes Hochfrequenzsignal zu schaffen, die bzw. das weitest möglich auch während des Pulsbetriebs des Hochfrequenzsignals aktiviert ist.

Die Aufgabe wird durch eine erfindungsgemäße Vorrichtung zur Pegelregelung eines gepulsten Hochfrequenzsignals mit den Merkmalen des Patentanspruchs 1 und durch ein erfindungsgemäßes Verfahren zur Pegelregelung eines gepulsten Hochfrequenzsignals mit den Merkmalen des Patentanspruchs 10 gelöst. Vorteilhafte technische Erweiterungen sind in den jeweils abhängigen Patentansprüchen aufgeführt.

Erfindungsgemäß wird der Pegelregler mit einem Signal angesteuert, das aus der Verknüpfung des am Ausgang des Pulsmodulator gemessenen Signalpegels des gepulsten Hochfrequenzsignals und des gemessenen Signalpegel des Pulssignals - als Quotient des gemessenen Signalpegels des gepulsten Hochfrequenzsignals durch den gemessenen Signalpegel des Pulssignals - hervorgeht. Als Signalpegel wird bevorzugt die zeitveränderliche Leistung des jeweiligen Signals gemessen. Alternativ kann als Signalpegel auch die zeitveränderliche Amplitude des jeweiligen Signals erfassen werden.

Vernachlässigt man das transiente Verhalten des Signalpegels des gepulsten Hochfrequenzsignals beim Übergang von einer Pulspause zu einem Puls oder von einem Puls zu einer Pulspause des Pulssignals und bei einer störungsbedingten Drift des Signalpegels des gepulsten Hochfrequenzsignals, so weist der Quotient des gemessenen Signalpegels des gepulsten Hochfrequenzsignals durch den gemessenen Signalpegel des Pulssignals bei Vorliegen von stationären Verhältnissen - das heißt nach Abschluss des transienten Vorgangs - sowohl im Fall einer Pulspause als auch im Fall eines Pulses des Pulssignals immer wieder die gleichen Wert auf.

Auf diese Weise ist es möglich, nicht nur während der Puls-Phasen des Pulssignals eine Pegelregelung durchzuführen, sondern während der Pulse und der Pulspausen des Pulssignals mit Ausnahme des weiter unten noch erläuterten Ausnahmefalles kontinuierlich den Pegel des gepulsten HF-Signals zu regeln. Somit sind im eingeschwungen Zustand der Pegelregelung nach Abschluss des transienten Vorgangs Regelbandbreiten kleiner als 1 Hz möglich, da nur noch vergleichsweise langsame Driften des Signalpegels des gepulsten Hochfrequenzsignals auszuregeln sind.

Dies ermöglicht, wie weiter unten noch erwähnt wird, eine vergleichsweise rauscharme Pegelregelung.

Damit dieses Verhalten der Pegelregelung auftritt, sollten die Signalpfade vom Detektor, der den Signalpegel des Pulssignals misst, bis zur Einheit, die die Quotientenbildung durchführt, und vom Detektor, der den Signalpegel des gepulsten Hochfrequenzsignals misst, bis zur Einheit, die die Quotientenbildung durchführt, hinsichtlich der stationären und der dynamischen Eigenschaften vorzugsweise identisch sein. Zur Erzielung identischer stationärer Eigenschaften sollten die beiden Detektoren identische Verstärkungsfaktoren aufweisen. Um hinsichtlich der Dynamik identisches Verhalten zu realisieren, sollten die beiden Detektoren vorzugsweise identische Anstiegs- und Abfallzeiten sowie identische Bandbreiten aufweisen. Außerdem erfordert identisches dynamisches Verhalten in den beiden Signalpfaden vorzugsweise identische Laufzeiten vom jeweiligen Detektor zur Einheit, die die Quotientenbildung durchführt.

Sinkt die Differenz zwischen dem gemessenen Signalpegel des gepulsten Hochfrequenzsignals und dem gemessenen Signalpegel des Pulssignals unter einen vorgegebenen zweiten Schwellwert, so wird innerhalb der Pegelregelung von der Quotientenbildung auf eine Differenzbildung zwischen dem gemessenen Signalpegel des gepulsten Hochfrequenzsignals und dem Signalpegel des Pulssignals umgeschaltet. Auf diese Weise nähert sich bei zu Null konvergierender Differenz der erfassten Signalpegel zwischen dem Pulssignal und dem gepulsten Hochfrequenzsignal der integrierende Anteil des als proportional-integrierender Regler realisierten Pegelreglers einem konstanten Wert und der Ausregelvorgang der Pegelregelung ist abgeschlossen.

Da den beiden Signalen, die die beiden Detektoren in Abhängigkeit des Signalpegels des jeweils gemessenen Signals erzeugen, ein nicht zu vermeidendes Rauschen zusätzlich überlagert ist, ist dieses Rauschen im Falle eines niedrigen Signal-Rausch-Abstands durch entsprechende Einstellung der Regelbandbreite des Pegelreglers - Tiefpass-Charakteristik mit geeignet gewählter Grenzfrequenz - vorzugsweise zu dämpfen bzw. zu beseitigen.

In Pulspausen des Pulssignals wird der Signalpegel des Pulssignals mit einem geeignet gewählten ersten Schwellwert verglichen. Sinkt der Signalpegel des Pulssignals bei längeren Pulspausen des Pulssignals unter den ersten Schwellwert, so wird der Pegelregler angehalten. Auf diese Weise wird verhindert, dass die dem Pegelregler zugeführte Differenz zwischen den erfassten Signalpegeln des Pulssignals und des gepulsten Hochfrequenzsignals nur noch Rauschsignalanteile aufweist und somit keine sinnvolle Einstellung des Signalpegels des gepulsten Hochfrequenzsignals möglich ist.

Das erfindungsgemäße Verfahren und die erfindungsgemäße Vorrichtung zur Pegelregelung eines gepulsten Hochfrequenzsignals wird im Folgenden anhand der Zeichnung im Detail erläutert. Die Figuren der Zeichnung zeigen:

Fig. 1    ein Blockdiagramm eines Ausführungsbeispiels der erfindungsgemäßen Vorrichtung zur Pegelregelung eines gepulsten Hochfrequenzsignals und

Fig. 2    ein Flussdiagramm eines Ausführungsbeispiels des erfindungsgemäßen Verfahrens zur Pegelregelung eines gepulsten Hochfrequenzsignals.

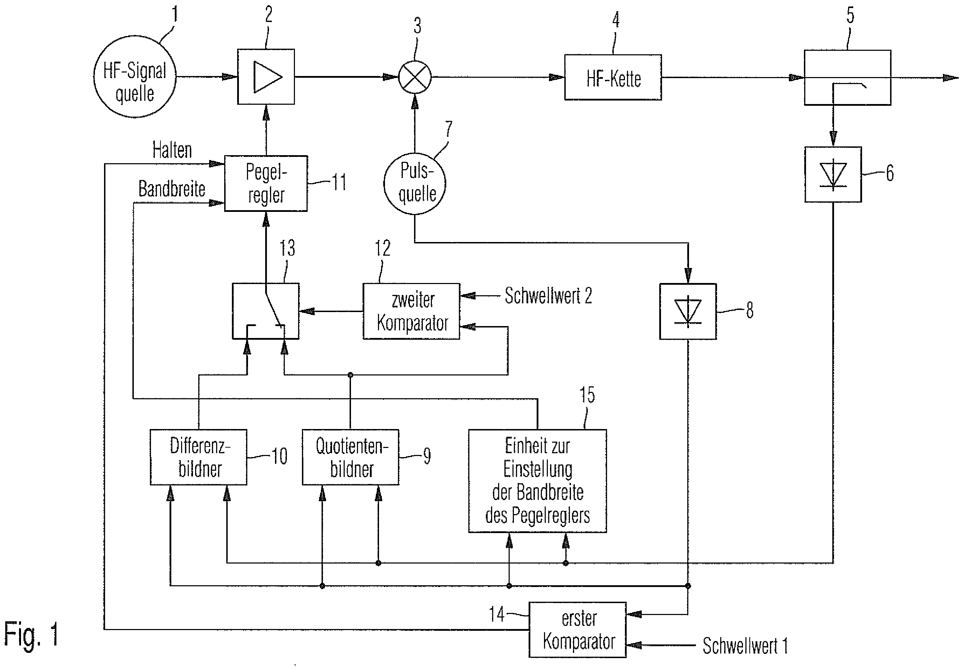

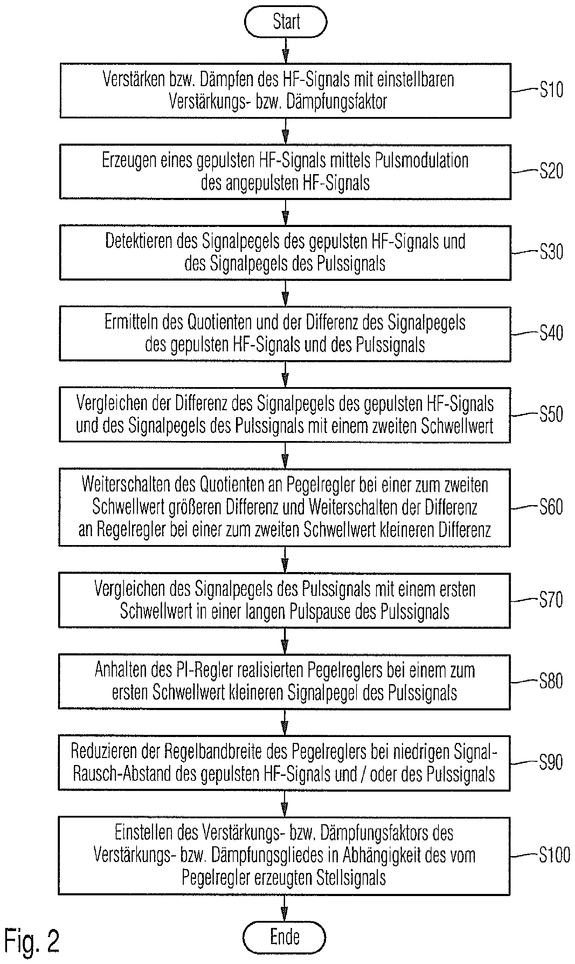

Im Folgenden wird das Ausführungsbeispiel des erfindungsgemäßen Verfahrens zur Pegelregelung eines gepulsten Hochfrequenzsignals anhand des Flussdiagramms in Fig. 2 in Kombination mit dem Ausführungsbeispiel der erfindungsgemäßen Vorrichtung zur Pegelregelung eines gepulsten Hochfrequenzsignals anhand des Blockdiagramms Fig. 1 im Detail erläutert.

Im ersten Verfahrensschritt S10 wird das von einer Hochfrequenz-Signalquelle 1 - bevorzugt von einem Hochfrequenz-Synthesizer - erzeugte ungepulste Hochfrequenzsignal in einem hinsichtlich seines Verstärkungs- bzw. Dämpfungsfaktors einstellbaren Verstärkungs- bzw. Dämpfungsglied 2 verstärkt bzw. gedämpft.

Im nächsten Verfahrensschritt S20 wird das verstärkte bzw. gedämpfte, ungepulste Hochfrequenzsignal in einem Pulsmodulator 3 mittels eines Pulssignals in ein gepulstes Hochfrequenzsignals gewandelt.

Das gepulste Hochfrequenzsignal wird im darauffolgenden Verfahrensschritt S30 über einen Richtkoppler 5 aus dem an den Pulsmodulator 3 anschließenden Hochfrequenz-Pfad 4, der bevorzugt als Hochfrequenz-Kette oder Hochfrequenz-Leitung ausgeführt ist, ausgekoppelt. Das ausgekoppelte gepulste Hochfrequenzsignal wird in einem anschließenden Hochfrequenz-Detektor 6 hinsichtlich seines Signalpegels erfasst. Bei dem Hochfrequenz-Detektor 6 handelt es sich bevorzugt um einen sogenannten RMS-Detektor (Root Mean Square, deutsch: Wurzel des quadratischen Mittelwerts), der die tatsächliche Leistung des gepulsten Hochfrequenzsignals unabhängig von dessen Zeitverlauf misst. Alternativ können natürlich auch andere Leistungs-Detektoren für Hochfrequenzsignale wie beispielsweise der Average-(AV)-Detektor (deutsch: Mittelwert-Detektor) verwendet werden und sind von der Erfindung mit abgedeckt. Auch Detektoren zur Erfassung der Amplitude - des Spitzenwertes - des gepulsten Hochfrequenzsignals sind zu Erfassung des Signalpegels des gepulsten Hochfrequenzsignals anwendbar und von der Erfindung mit abgedeckt.

Parallel wird im gleichen Verfahrensschritt S30 der Signalpegel des von einer Pulsquelle 7 erzeugten und dem Pulsmodulator 3 zugeführten Pulssignals in einem Detektor 8 zur Erfassung des Signalpegels des Pulssignals detektiert. Auch hier können geeignete Detektoren zur Erfassung der Signalleistung oder der Signalamplitude eines Pulssignals verwendet werden und sind von der Erfindung mit abgedeckt.

Im darauf folgenden Verfahrensschritt S40 werden in einer Einheit 9 zur Bildung eines Quotienten gemäß Gleichung (1) der Quotient $Q(t)$ des erfassten Signalpegels $Soll(t)$ des Pulssignals durch den erfassten Signalpegels $Ist(t)$ des gepulsten Hochfrequenzsignals und in einer Einheit 10 zur Bildung einer Differenz gemäß Gleichung (2) die Differenz $D(t)$ zwischen dem erfassen Signalpegel $Soll(t)$ des Pulssignals und dem erfassten Signalpegel $Ist(t)$ des gepulsten Hochfrequenzsignals bestimmt.

$$Q(t) = \frac{Soll(t)}{Ist(t)} \qquad\qquad (1)$$

$$D(t) = Soll(t) - Ist(t) \qquad\qquad (2)$$

Da der noch zur erläuternde Pegelregler 11 als proportional-integrierender Regler ausgeführt ist, würde ein typischerweise von Null verschiedener konstanter Wert des Quotienten $Q(t)$ in den Puls-Phasen des Pulssignals zu einem kontinuierlich ansteigenden Signal am Ausgang des zum proportional-integrierenden Regler gehörigen Integrators und damit zu einem kontinuierlich ansteigenden Stellsignal anstelle eines sich auf einen konstanten Wert einregelnden Stellsignals am Ausgang des Pegelregler 11 führen. Zur Vermeidung dieses unerwünschten Regelverhaltens des Pegelreglers 11 wird bei kleiner werdender Differenz zwischen dem erfassten Signalpegeln des Pulssignals und des gepulsten Hochfrequenzsignals der Pegelregler 11 mit der Differenz $D(t)$ zwischen den erfassten Signalpegeln des Pulssignals und des gepulsten Hochfrequenzsignals anstelle des Quotienten $Q(t)$ des erfassen Signalpegels des Pulssignals durch den erfassten Signalpegel des gepulsten Hochfrequenzsignals angesteuert. Eine im Regelvorgang gegen Null konvergierende Differenz $D(t)$ zwischen den erfassten Signalpegeln des Pulssignals und des gepulsten Hochfrequenzsignals führt nach Abschluss des Ausregelvorgangs zu einem Stellsignal am Ausgang des Pegelreglers 11 mit einem konstanten Wert.

Hierzu wird im nächsten Verfahrensschritt S50 in einem zweiten Komparator 12 die in der Einheit 10 zur Bildung einer Differenz erzeugte Differenz $D(t)$ zwischen den erfassten Signalpegeln des Pulssignals und des gepulsten Hochfrequenzsignals mit einem geeignet gewählten zweiten Schwellwert verglichen.

Solange die Differenz $D(t)$ zwischen den erfassten Signalpegeln des Pulssignals und des gepulsten Hochfrequenzsignals oberhalb des zweiten Schwellwerts liegt und sich die Pegelregelung somit in einer Grob-Phase des Ausregelvorgangs befindet, wird der Pegelregler 11 im darauf folgenden Verfahrensschritt S60 über einen vom Ausgangssignal des zweiten Komparators 12 angesteuerten Schalter 13 mit dem Quotienten $Q(t)$ des erfassten Signalpegels des Pulssignals durch den erfassten Signalpegel des gepulsten Hochfrequenzsignals versorgt. Sinkt die Differenz $D(t)$ zwischen den erfassten Signalpegeln des Pulssignals und des gepulsten Hochfrequenzsignals unter den zweiten Schwellwert und befindet sich somit die Pegelregelung in der Fein-Phase des Ausregelvorgangs, so wird über den Schalter 13 die Differenz $D(t)$ zwischen den erfassten Signalpegeln des Pulssignals und des gepulsten Hochfrequenzsignals an den Pegelregler 11 weitergeschaltet.

Da die von den beiden Detektoren 6 und 8 erzeugten Signale nicht nur von den erfassten Signalpegeln des gepulsten Hochfrequenzsignals und des Pulssignals abhängen, sondern auch noch überlagerte Rauschsignalanteile aufweisen, weist der Quotient $Q(t)$ gemäß Gleichung (3) und die Differenz $D(t)$ gemäß Gleichung (4) neben den erfassten Signalpegeln $Soll(t)$ und $Ist(t)$ des Pulssignals und des gepulsten Hochfrequenzsignals auch noch die Rauschsignal-Anteile $N_{Soll}(t)$ im Signalpfad des erfassten Signalpegels des Pulssignals und $N_{Ist}(t)$ im Signalpfad des erfassten Signalpegels des gepulsten Hochfrequenzsignals auf. Bei einem großen Signal-Rausch-Abstand, sind die Einflüsse der Rauschsignalanteile $N_{Soll}(t)$ und $N_{Ist}(t)$ auf den einzustellenden Signalpegel des gepulsten Hochfrequenzsignals vernachlässigbar. Diese Rauschsignal-Anteile werden aber bei einem geringen Signal-Rausch-Abstand, insbesondere bei kurzen Pulsen und langen Pulspausen des Pulssignals, über den Pegelregler 11 unerwünscht auf den durch die Pegelregelung eingestellten Signalpegel des gepulsten Hochfrequenzsignals moduliert und können nicht immer vernachlässigt werden.

$$Q(t) = \frac{Soll(t) + N_{Soll}(t)}{Ist(t) + N_{Ist}(t)} \qquad\qquad (3)$$

$$D(t) = Soll(t) + N_{Soll}(t) - Ist(t) - N_{Ist}(t) \qquad\qquad (4)$$

Äußerst kritisch ist die Situation in längeren Pulspausen des Pulssignals, in denen nicht nur der erfasste Signalpegel *Soll*(*t*) des Pulssignals Null ist, sondern auch der erfasste Signalpegel *Ist*(*t*) des gepulsten Hochfrequenzsignals sich dem Wert Null annähert. In diesem Fall erhält der Pegelregler als Ansteuersignal gemäß Gleichung (5) nur noch die Differenz *D'*(*t*) zwischen den beiden Rauschsignal-Anteilen $N_{Soll}$(*t*) und $N_{Ist}$(*t*) und kann daraus kein praktikables Stellsignal zur Einstellung des Verstärkungs-bzw. Dämpfungsfaktors des Verstärkungs-bzw. Dämpfungsgliedes 2 ermitteln.

$$D'(t) = N_{Soll}(t) - N_{Ist}(t) \qquad\qquad (5)$$

Zur Vermeidung des zuletzt genannten äußerst kritischen Zustandes wird im nachfolgenden Verfahrensschritt S70 der erfasste Signalpegel *Soll*(*t*) des Pulssignals in einem ersten Komparator 14 mit einem ersten geeignet gewählten Schwellwert verglichen. Die Wahl des ersten Schwellwertes hängt einerseits von der geforderten Pegel-Genauigkeit des gepulsten Hochfrequenzsignals und andererseits von der verwendeten Hardware des Pegelregelkreises, insbesondere von der Genauigkeit der analog oder digital realisierten Detektoren 6 und 8, der digitalen Auflösung der typischerweise digital realisierten Funktionseinheiten des Pegelregelung und Genauigkeit in der Einstellbarkeit des Verstärkungs-bzw. Dämpfungsfaktors des Verstärkungs- bzw. Dämpfungsgliedes 2, ab und ist geeignet zu dimensionieren.

Sinkt der erfasste Signalpegel *Soll*(*t*) des Pulssignals unter den ersten Schwellwert und liegt somit eine Differenz-Wert *D'*(*t*) vor, der nur von den Rauschsignalanteilen $N_{Soll}$(*t*) im Signalpfad des erfassten Signalpegels des Pulssignals und $N_{Ist}$(*t*) im Signalpfad des erfassten Signalpegels des gepulsten Hochfrequenzsignals abhängig ist, so wird im nächsten Verfahrensschritt S80 der Pegelregler 11 auf dem aktuell ermittelten Wert des Stellsignal angehalten und solange eingefroren, bis der erfasste Signalpegel *Soll*(*t*) des Pulssignals den ersten Schwellwert wieder überschreitet.

Zur Vermeidung einer unerwünschten Modulation der Rauschsignal-Anteile auf den Signalpegel des gepulsten Hochfrequenzsignals im Fall eines geringen Signal-Rausch-Abstands im Signalpfad der von den beiden Detektoren 6 und 8 erzeugten Detektor-Signale wird im nächsten Verfahrensschritt S90 in einer Einheit 15 zur Einstellung der Bandbreite des Pegelreglers der Signal-Rausch-Abstand im Ausgangssignal des Hochfrequenz-Detektors 6 und des Detektors 8 zur Messung des Signalpegel des Pulssignals ermittelt und mit einem dritten geeignet gewählten Schwellwert verglichen. Liegen die beiden ermittelten Signal-Rauschabstände unterhalb des dritten Schwellwerts und ist somit mit einem starken Amplitudenrauschen des Signalpegels des gepulsten Hochfrequenzsignals zu rechnen, wird auf Veranlassung der Einheit 15 zur Einstellung der Bandbreite des Pegelregler die Bandbreite des Pegelreglers 11 durch Verstellen der Nachstellzeit des im proportional-integrierenden Pegelregler 11 enthaltenen Integrators geeignet reduziert.

Im abschließenden Verfahrensschritt S100 wird der Verstärkungs- bzw. Dämpfungsfaktor des Verstärkungs-bzw. Dämpfungsgliedes 2 in Abhängigkeit des vom Pegelregler 11 erzeugte Stellsignals eingestellt oder angehalten.

Die erfindungsgemäße Vorrichtung und das erfindungsgemäße Verfahren zur Pegelregelung eines gepulsten Hochfrequenzsignals sind nicht auf die dargestellte Ausführungsform beschränkt. Die Erfindung wird vielmehr durch die Ansprüche definiert.

**Patentansprüche**

1. Vorrichtung zur Pegelregelung eines gepulsten Hochfrequenzsignals mit einem hinsichtlich seines Verstärkungs-bzw. Dämpfungsfaktors einstellbaren und von einem ungepulsten Hochfrequenzsignal beaufschlagten Verstärkungs- bzw. Dämpfungsglied (2), einem nachfolgenden von einem Pulssignal angesteuerten Pulsmodulator (3), einem nachfolgenden Hochfrequenz-Detektor (6) zur Messung eines Signalpegels (*Ist*(*t*)) eines am Ausgang des Pulsmodulators (3) erzeugten gepulsten Hochfrequenzsignals, einer Einheit (9;10) zur Verknüpfung des Signalpegels (*Ist*(*t*)) des gepulsten Hochfrequenzsignals mit dem Signalpegel (*Soll*(*t*)) des Pulssignals und einem von der Einheit (9;10) zur Verknüpfung des Signalpegels (*Ist*(*t*)) des gepulsten Hochfrequenzsignals mit dem Signalpegel (*Soll*(*t*)) des Pulssignals mittels des mit dem Signalpegel des Pulssignals (Soll(t)) verknüpften Signalpegels des gepulsten Hochfrequenzsignals (Ist(t)) angesteuerten Pegelregler (11) zur Einstellung des Verstärkungs- bzw. Dämpfungsfaktors des Verstärkungs- bzw. Dämpfungsgliedes (2),
**dadurch gekennzeichnet,**
**dass** die Einheit (9;10) zur Verknüpfung des Signalpegels (*Ist*(*t*)) des gepulsten Hochfrequenzsignals mit dem Signalpegel (*Soll*(*t*)) des Pulssignals eine Einheit (9) zur Bildung des Quotienten (*Q*(*t*)) des Signalpegels (*Soll*(*t*)) des Pulssignals durch den Signalpegel (*Ist*(*t*)) des gepulsten Hochfrequenzsignals ist.

2. Vorrichtung zur Pegelregelung nach Anspruch 1, **dadurch gekennzeichnet,**
**dass** zur Ansteuerung des Pegelreglers ferner eine Einheit (9;10) zur Verknüpfung des Signalpegels (*Ist*(*t*)) des gepulsten Hochfrequenzsignals mit dem Signalpegel (*Soll*(*t*)) des Pulssignals vorgesehen ist, die eine Einheit (10) zur Bildung der Differenz des Signalpegels (*Soll*(*t*)) des Pulssignals durch den Signalpegel (*Ist*(*t*)) des gepulsten Hochfrequenzsignals ist.

3. Vorrichtung zur Pegelregelung nach Anspruch 1 oder 2, **dadurch gekennzeichnet,**
   **dass** ein Detektor (8) zur Messung eines Signalpegels (*Soll*(*t*)) des Pulssignals vorgesehen ist und der Detektor zur Messung eines Signalpegels (*Soll*(*t*)) des Pulssignals und der Hochfrequenz-Detektor (6) identische Anstiegs- und Abfallzeiten aufweisen.

4. Vorrichtung zur Pegelregelung nach Anspruch 3, **dadurch gekennzeichnet,**
   **dass** der Detektor (8) zur Messung eines Signalpegels (*Soll*(*t*)) des Pulssignals und der Hochfrequenz-Detektor (6) identische Bandbreiten aufweisen.

5. Vorrichtung zur Pegelregelung nach Anspruch 3 oder 4, **dadurch gekennzeichnet,**
   **dass** die Laufzeit des vom Detektor (8) zur Messung eines Signalpegels (*Soll*(*t*)) des Pulssignals erzeugten Signals identisch zur Laufzeit des vom Hochfrequenz-Detektor (6) erzeugten Signals ist.

6. Vorrichtung zur Pegelregelung nach einem der Ansprüche 1 bis 5,
   **dadurch gekennzeichnet,**
   **dass** dem Pegelregler (11) eine Einheit (15) zur Einstellung der Bandbreite des Pegelreglers vorgeschalten ist.

7. Vorrichtung zur Pegelregelung nach einem der Ansprüche 1 bis 6,
   **dadurch gekennzeichnet,**
   **dass** dem Pegelregler (11) ein erster Komparator (14) zum Vergleich des Signalpegels (*Soll*(*t*)) des Pulssignals mit einem ersten Schwellwert vorgeschalten ist.

8. Vorrichtung zur Pegelregelung nach einem der Ansprüche 1 bis 7,
   **dadurch gekennzeichnet,**
   **dass** dem Pegelregler (11) ein Schalter (13) zur Weiterschaltung des Quotienten (*Q*(*t*)) oder der Differenz (*D*(*t*)) des gemessenen Signalpegels (*Ist*(*t*)) des gepulsten Hochfrequenzsignals und des gemessenen Signalpegels (*Soll*(*t*)) des Pulssignals vorgeschaltet ist.

9. Vorrichtung zur Pegelregelung nach Anspruch 8, **dadurch gekennzeichnet,**
   **dass** die Ansteuerung des Schalters (13) über einen zweiten Komparator (12) zum Vergleich der Differenz (*D*(*t*)) des gemessenen Signalpegels (*Ist*(*t*)) des gepulsten Hochfrequenzsignals und des gemessenen Signalpegels (*Soll*(*t*)) des Pulssignals mit einem zweiten Schwellwert erfolgt.

10. Verfahren zur Pegelregelung eines gepulsten Hochfrequenzsignals mit folgenden Verfahrensschritten:

    • Verstärken bzw. Dämpfen eines ungepulsten Hochfrequenzsignals mit einem hinsichtlich seines Verstärkungs- bzw. Dämpfungsfaktors einstellbaren Verstärkungs- bzw. Dämpfungsglied (2),
    • Erzeugen eines gepulsten Hochfrequenzsignals aus dem ungepulsten Hochfrequenzsignal mit einem von einem Pulssignal angesteuerten Pulsmodulator (3),
    • Messen eines Signalpegels des gepulsten Hochfrequenzsignals am Ausgang des Pulsmodulators mit einem Hochfrequenz-Detektor (6),
    • Verknüpfen des gemessenen Signalpegel (*Ist*(*t*)) des gepulsten Hochfrequenzsignals mit dem gemessenen Signalpegel (*Soll*(*t*)) des Pulssignals,
    • Einstellen des Verstärkungs- bzw. Dämpfungsfaktors des Verstärkungs- bzw. Dämpfungsgliedes (2) mit einem Pegelregler (11), der von dem mit dem gemessenen Signalpegel (*Soll*(*t*)) des Pulssignals verknüpften gemessenen Signalpegel (*Ist*(*t*)) des gepulsten Hochfrequenzsignals angesteuert wird,

    **dadurch gekennzeichnet,**
    **dass** zur Ansteuerung des Pegelreglers (11) der Quotient (*Q*(*t*)) des gemessenen Signalpegels (*Soll*(*t*)) des Pulssignals durch den gemessenen Signalpegel (*Ist*(*t*)) des gepulsten Hochfrequenzsignals verwendet wird.

11. Verfahren zur Pegelregelung nach Ansprüche 10, **dadurch gekennzeichnet,**
    **dass** in Zeiten, in denen ein kleiner Signal-Rausch-Abstand des gemessenen Signalpegels (*Soll*(*t*)) des Pulssignals und/oder ein kleiner Signal-Rausch-Abstand des gemessenen Signalpegels (*Ist*(*t*)) des gepulsten Hochfrequenzsignals vorliegen, die Regelbandbreite des Pegelreglers (11) reduziert wird.

**12.** Verfahren zur Pegelregelung nach Anspruch 11, **dadurch gekennzeichnet,**
**dass** bei kurzen Pulsen und langen Pulspausen des Pulssignals die Regelbandbreite des Pegelreglers (11) reduziert wird.

**13.** Verfahren zur Pegelregelung nach einem der Ansprüche 10 bis 12,
**dadurch gekennzeichnet,**
**dass** bei langen Pulspausen des Pulssignals und bei einem gemessenen Signalpegel (*Soll(t)*) des Pulssignals, der kleiner als ein erster Schwellwert ist, der Pegelregler (11) angehalten wird.

**14.** Verfahren zur Pegelregelung nach einem der Ansprüche 10 bis 13,
**dadurch gekennzeichnet,**
**dass** bei einer gegenüber einem zweiten Schwellwert kleineren Differenz (*D(t)*) zwischen dem gemessenen Signalpegel (*Soll(t)*) des Pulssignals und dem gemessenen Signalpegel (*Ist(t)*) des gepulsten Hochfrequenzsignals der Pegelregler mit der Differenz (*D(t)*) zwischen dem gemessenen Signalpegel (*Soll(t)*) des Pulssignals und dem gemessenen Signalpegel (*Ist(t)*) des gepulsten Hochfrequenzsignals angesteuert wird.

**Claims**

**1.** Device for controlling the level of a pulsed high frequency signal with an amplification or attenuation element (2) which is adjustable with respect to its amplification or attenuation factor and supplied with an unpulsed high frequency signal, a following downstream pulse modulator (3) which is actuated by a pulse signal, a following downstream high frequency detector (6) for measuring a signal level (*Ist(t)*) of a pulsed high frequency signal generated at the output of the pulse modulator (3), a unit (9; 10) for linking the signal level (*Ist(t)*) of the pulsed high frequency signal with the signal level (*Soll(t)*) of the pulse signal, and a level controller (11) which is actuated by the unit (9; 10) for linking the signal level (*Ist(t)*) of the pulsed high frequency signal with the signal level (*Soll(t)*) of the pulse signal by means of the signal level of the pulsed high frequency signal (*Ist(t)*) linked with the signal level of the pulse signal (*Soll(t)*) and serves for adjusting the amplification or attenuation factor of the amplification or attenuation element (2), **characterised in that**
the unit (9; 10) for linking the signal level (*Ist(t)*) of the pulsed high frequency signal with the signal level (*Soll(t)*) of the pulse signal is a unit (9) for forming the quotient (*Q(t)*) of the signal level (*Soll(t)*) of the pulse signal over the signal level (*Ist(t)*) of the pulsed high frequency signal.

**2.** Device for controlling the level according to claim 1,
**characterised in that**
for actuating the level controller in addition a unit (9; 10) is provided for linking the signal level (*Ist(t)*) of the pulsed high frequency signal with the signal level (*Soll(t)*) of the pulse signal, which unit is a unit (10) for forming the difference between the signal level (*Soll(t)*) of the pulse signal and the signal level (*Ist(t)*) of the pulsed high frequency signal.

**3.** Device for controlling the level according to claim 1 or 2,
**characterised in that**
a detector (8) is provided for measuring a signal level (*Soll(t)*) of the pulse signal and the detector for measuring a signal level (*Soll(t)*) of the pulse signal and the high frequency detector (6) have identical rise and fall times.

**4.** Device for controlling the level according to claim 3,
**characterised in that**
the detector (8) for measuring a signal level (*Soll(t)*) of the pulse signal and the high frequency detector (6) have identical band widths.

**5.** Device for controlling the level according to claim 3 or 4,
**characterised in that**
the delay time of the signal generated by the detector (8) for measuring a signal level (*Soll(t)*) of the pulse signal is identical to the delay time of the signal generated by the high frequency detector (6).

**6.** Device for controlling the level according to one of claims 1 to 5, **characterised in that**
a unit (15) for adjusting the band width of the level controller is connected upstream of the level controller (11).

**7.** Device for controlling the level according to one of claims 1 to 6, **characterised in that**

a first comparator (14) for comparing the signal level (*Soll(t)*) of the pulse signal with a first threshold value is connected upstream of the level controller (11).

**8.** Device for controlling the level according to one of claims 1 to 7, **characterised in that**
a switch (13) for further switching of the quotient (*Q(t)*) or the difference (*D(t)*) of the measured signal level (*Ist(t)*) of the pulsed high frequency signal and the measured signal level (*Soll(t)*) of the pulse signal is connected upstream of the level controller (11).

**9.** Device for controlling the level according to claim 8,
**characterised in that**
the actuation of the switch (13) is carried out by means of a second comparator (12) for comparing the difference (*D(t)*) of the measured signal level (*Ist(t)*) of the pulsed high frequency signal and the measured signal level (*Soll(t)*) of the pulse signal with a second threshold value.

**10.** Method for controlling the level of a pulsed high frequency signal with the following method steps:

• amplification or attenuation of an unpulsed high frequency signal with an amplification or attenuation element (2) which is adjustable with respect to its amplification or attenuation factor,
• generation of a pulsed high frequency signal from the unpulsed high frequency signal with a pulse modulator (3) which is actuated by a pulse signal,
• measurement of a signal level of the pulsed high frequency signal at the output of the pulse modulator with a high frequency detector (6),
• linking of the measured signal level (*Ist(t)*) of the pulsed high frequency signal with the measured signal level (*Soll(t)*) of the pulse signal,
• adjustment of the amplification or attenuation factor of the amplification or attenuation element (2) with a level controller (11) which is actuated by the measured signal level (*Ist(t)*) of the pulsed high frequency signal linked with the measured signal level (*Soll(t)*) of the pulse signal,

**characterised in that**
the quotient (*Q(t)*) of the measured signal level (*Soll(t)*) of the pulse signal over the measured signal level (*Ist(t)*) of the pulsed high frequency signal is used for actuating the level controller (11).

**11.** Method for controlling the level according to claim 10,
**characterised in that**
in times in which a small signal-to-noise interval of the measured signal level (*Soll(t)*) of the pulse signal and/or a small signal-to-noise interval of the measured signal level (*Ist(t)*) of the pulsed high frequency signal is/are present, the control band width of the level controller (11) is reduced.

**12.** Method for controlling the level according to claim 11,
**characterised in that**
with short pulses and long pulse pauses of the pulse signal the control band width of the level controller (11) is reduced.

**13.** Method for controlling the level according to one of claims 10 to 12, **characterised in that**
with long pulse pauses of the pulse signal and with a measured signal level (*Soll(t)*) of the pulse signal which is less than a first threshold value, the level controller (11) is stopped.

**14.** Method for controlling the level according to one of claims 10 to 13, **characterised in that**
with a difference (*D(t)*), which is less than a second threshold value between the measured signal level (*Soll(t)*) of the pulse signal and the measured signal level (*Ist(t)*) of the pulsed high frequency signal, the level controller is actuated with the difference (*D(t)*) between the measured signal level (*Soll(t)*) of the pulse signal and the measured signal level (*Ist(t)*) of the pulsed high frequency signal.

**Revendications**

**1.** Dispositif de régulation de niveau d'un signal haute fréquence pulsé avec un élément amplificateur ou atténuateur (2) dont le facteur d'amplification ou d'atténuation est réglable et soumis à un signal haute fréquence non pulsé, un modulateur d'impulsions (3) consécutif commandé par un signal d'impulsion, un détecteur haute fréquence (6) consécutif pour la mesure d'un niveau de signal (*Ist(t)*) d'un signal haute fréquence pulsé généré à la sortie du modulateur d'impulsions (3), une unité (9 ; 10) pour la liaison du niveau de signal (*Ist(t)*) du signal haute fréquence pulsé avec le niveau de signal (*Soll(t)*) du signal d'impulsion et un régulateur de niveau (11) commandé par l'unité (9 ; 10) pour la liaison du niveau de signal (*Ist(t)*) du signal haute fréquence pulsé avec le niveau de signal (*Soll(t)*) du signal d'impulsion au moyen du niveau de signal du signal haute fréquence pulsé (*Ist(t)*) lié au niveau de signal du signal d'impulsion (*Soll(t)*), pour le réglage du facteur d'amplification ou d'atténuation de l'élément amplificateur ou atténuateur (2),

**caractérisé en ce que**

l'unité (9 ; 10) pour la liaison du niveau de signal (*Ist(t)*) du signal haute fréquence pulsé avec le niveau de signal (*Soll(t)*) du signal d'impulsion est une unité (9) pour la formation du quotient (*Q(t)*) du niveau de signal (*Soll(t)*) du signal d'impulsion par le niveau de signal (*Ist(t)*) du signal haute fréquence pulsé.

2. Dispositif de régulation de niveau selon la revendication 1,
**caractérisé en ce que**

pour la commande du régulateur de niveau, une unité (9 ; 10) pour la liaison du niveau de signal (*Ist(t)*) du signal haute fréquence pulsé avec le niveau de signal (*Soll(t)*) du signal d'impulsion est en outre prévue, laquelle est une unité (10) pour la formation de la différence du niveau de signal (*Soll(t)*) du signal d'impulsion par le niveau de signal (*Ist(t)*) du signal haute fréquence pulsé.

3. Dispositif de régulation de niveau selon la revendication 1 ou la revendication 2,
**caractérisé en ce que**

un détecteur (8) pour la mesure d'un niveau de signal (*Soll(t)*) du signal d'impulsion est prévu, et **en ce que** le détecteur pour la mesure d'un niveau de signal (*Soll(t)*) du signal d'impulsion et le détecteur haute fréquence (6) présentent des temps de montée et des temps de descente identiques.

4. Dispositif de régulation de niveau selon la revendication 3,
**caractérisé en ce que**

le détecteur (8) pour la mesure d'un niveau de signal (*Soll(t)*) du signal d'impulsion et le détecteur haute fréquence (6) présentent des largeurs de bande identiques.

5. Dispositif de régulation de niveau selon la revendication 3 ou la revendication 4,
**caractérisé en ce que**

la durée du signal généré par le détecteur (8) pour la mesure d'un niveau de signal (*Soll(t)*) du signal d'impulsion est identique à la durée du signal généré par le détecteur haute fréquence (6).

6. Dispositif de régulation de niveau selon l'une des revendications 1 à 5,
**caractérisé en ce que**

une unité (15) de réglage de la largeur de bande du régulateur de niveau est disposée en amont du régulateur de niveau (11).

7. Dispositif de régulation de niveau selon l'une des revendications 1 à 6,
**caractérisé en ce que**

un premier comparateur (14) pour la comparaison du niveau de signal (*Soll(t)*) du signal d'impulsion avec une première valeur seuil est disposé en amont du régulateur de niveau (11).

8. Dispositif de régulation de niveau selon l'une des revendications 1 à 7,
**caractérisé en ce que**

un commutateur (13) pour la transmission du quotient (*Q(t)*) ou de la différence (*D(t)*) du niveau de signal (*Ist(t)*) mesuré du signal haute fréquence pulsé et du niveau de signal (*Soll(t)*) mesuré du signal d'impulsion est disposé en amont du régulateur de niveau (11).

9. Dispositif de régulation de niveau selon la revendication 8,
**caractérisé en ce que**

la commande du commutateur (13) est effectuée par un deuxième comparateur (12) pour la comparaison de la différence (*D(t)*) du niveau de signal (*Ist(t)*) mesuré du signal haute fréquence pulsé et du niveau de signal (*Soll(t)*) mesuré du signal d'impulsion avec une deuxième valeur seuil.

10. Procédé de régulation de niveau d'un signal haute fréquence pulsé, comprenant les étapes suivantes :

- amplification ou atténuation d'un signal haute fréquence non pulsé avec un élément amplificateur ou atténuateur (2) dont le facteur d'amplification ou d'atténuation est réglable,
- génération d'un signal haute fréquence pulsé à partir d'un signal haute fréquence non pulsé avec un modulateur d'impulsions (3) commandé par un signal d'impulsion,
- mesure d'un niveau de signal du signal haute fréquence pulsé à la sortie du modulateur d'impulsions avec un détecteur haute fréquence (6),
- liaison du niveau de signal (*Ist(t)*) mesuré du signal haute fréquence pulsé avec le niveau de signal (*Soll(t)*) mesuré du signal d'impulsion,
- réglage du facteur d'amplification ou d'atténuation de l'élément amplificateur ou atténuateur (2) avec un régulateur de niveau (11), lequel est commandé par le niveau de signal *(Ist(t))* mesuré du signal haute fréquence pulsé lié au niveau de signal (*Soll(t)*) mesuré du signal d'impulsion,

**caractérisé en ce que**

pour la commande du régulateur de niveau (11), le quotient (*Q(t)*) du niveau de signal (*Soll(t)*) mesuré du signal d'impulsion est utilisé par le niveau de signal (*Ist(t)*) mesuré du signal haute fréquence pulsé.

11. Procédé de régulation de niveau selon la revendication 10,
**caractérisé en ce que**
la bande passante d'adressage du régulateur de niveau (11) est réduite pendant les périodes où un faible rapport signal/bruit du niveau de signal (*Soll(t)*) mesuré du signal d'impulsion et/ou un faible rapport signal/bruit du niveau de signal (*Ist(t)*) mesuré du signal haute fréquence pulsé sont présentés.

12. Procédé de régulation de niveau selon la revendication 11,
**caractérisé en ce que**
la bande passante d'adressage du régulateur de niveau (11) est réduite en cas d'impulsions courtes et de pauses d'impulsions longues du signal d'impulsion.

13. Procédé de régulation de niveau selon l'une des revendications 10 à 12,
**caractérisé en ce que**
le régulateur de niveau (11) est arrêté en cas de pauses d'impulsions longues du signal d'impulsion et en cas de niveau de signal (*Soll(t)*) mesuré du signal d'impulsion inférieur à une première valeur seuil.

14. Procédé de régulation de niveau selon l'une des revendications 10 à 13,
**caractérisé en ce que**
en cas de différence (*D(t)*) inférieure par rapport à une deuxième valeur seuil entre le niveau de signal (*Soll(t)*) mesuré du signal d'impulsion et le niveau de signal (*Ist(t)*) mesuré du signal haute fréquence pulsé, le régulateur de niveau est commandé avec la différence (*D(t)*) entre le niveau de signal (*Soll(t)*) mesuré du signal d'impulsion et le niveau de signal (*Ist(t)*) mesuré du signal haute fréquence pulsé.

Fig. 1

Start

Verstärken bzw. Dämpfen des HF-Signals mit einstellbaren Verstärkungs- bzw. Dämpfungsfaktor — S10

Erzeugen eines gepulsten HF-Signals mittels Pulsmodulation des angepulsten HF-Signals — S20

Detektieren des Signalpegels des gepulsten HF-Signals und des Signalpegels des Pulssignals — S30

Ermitteln des Quotienten und der Differenz des Signalpegels des gepulsten HF-Signals und des Pulssignals — S40

Vergleichen der Differenz des Signalpegels des gepulsten HF-Signals und des Signalpegels des Pulssignals mit einem zweiten Schwellwert — S50

Weiterschalten des Quotienten an Pegelregler bei einer zum zweiten Schwellwert größeren Differenz und Weiterschalten der Differenz an Regelregler bei einer zum zweiten Schwellwert kleineren Differenz — S60

Vergleichen des Signalpegels des Pulssignals mit einem ersten Schwellwert in einer langen Pulspause des Pulssignals — S70

Anhalten des PI-Regler realisierten Pegelreglers bei einem zum ersten Schwellwert kleineren Signalpegel des Pulssignals — S80

Reduzieren der Regelbandbreite des Pegelreglers bei niedrigen Signal-Rausch-Abstand des gepulsten HF-Signals und / oder des Pulssignals — S90

Einstellen des Verstärkungs- bzw. Dämpfungsfaktors des Verstärkungs- bzw. Dämpfungsgliedes in Abhängigkeit des vom Pegelregler erzeugten Stellsignals — S100

Ende

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5054116 A